# EUROPÄISCHE PATENTSCHRIFT

(11) **EP 0 962 555 B1**
(45) Veröffentlichungstag und Bekanntmachung des Hinweises auf die Patenterteilung: **12.12.2001**
(21) Anmeldenummer: 99108645.5
(22) Anmeldetag: 12.05.1999
(51) Int. Cl.: C30B 15/00, C30B 29/06

(54) **Verfahren zur Herstellung eines Einkristalls**
Process for producing a single crystal
Procédé pour la préparation d'un monocristal

(30) Priorität: 28.05.1998 DE 19823962
(43) Veröffentlichungstag der Anmeldung: 08.12.1999
(73) Patentinhaber: Wacker Siltronic Gesellschaft für Halbleitermaterialien Aktiengesellschaft, 84489 Burghausen (DE)
(72) Erfinder: Ammon von, Wilfried, Dr., 5122 Hochburg/Ach (AT); Schmolke, Rüdiger, Dr., 84489 Burghausen (DE); Gräf, Dieter, Dr., 84489 Burghausen (DE); Lambert, Ulrich, Dr., 84547 Emmerting (DE)
(74) Vertreter: Rimböck, Karl-Heinz, Dr.

(56) Entgegenhaltungen:
- EP-A- 0 170 788
- EP-A- 0 527 477
- EP-A- 0 536 958
- EP-A- 0 829 559
- AMMON VON W ET AL: "THE DEPENDENCE OF BULK DEFECTS ON THE AXIAL TEMPERATURE GRADIENT OFSILICON CRYSTALS DURING CZOCHRALSKI GROWTH" JOURNAL OF CRYSTAL GROWTH, Bd. 151, Nr. 3/04, 1. Juni 1995, Seiten 273-277, XP000514096
- MADDALON-VINANTE C ET AL: "INFLUENCE OF RAPID THERMAL ANNEALING AND INTERNAL GETTERING ON CZOCHRALSKI-GROWN SILICON. I. OXYGEN PRECIPITATION" JOURNAL OF APPLIED PHYSICS, Bd. 79, Nr. 5, 1. März 1996, Seiten 2707-2711, XP000593848
- WATANABE: "Controlled oxygen doping in silicon" INTERNATIONAL CONFERENCE ON SOLID STATE DEVICES AND MATERIALS., Bd. 22, Nr. 1, 1983, Seiten 185-189, XP002105442 TOKYO JA
- DORNBERGER E ET AL: "Influence of boron concentration on the oxidation-induced stacking fault ring in Czochralski silicon crystals" JOURNAL OF CRYSTAL GROWTH, Bd. 180, Nr. 3-4, 1. Oktober 1997, Seite 343-352 XP004096634
- PATENT ABSTRACTS OF JAPAN vol. 018, no. 680 (C-1291), 21. Dezember 1994 & JP 06 271399 A (NIPPON STEEL CORP;OTHERS: 01), 27. September 1994
- VORONKOV: "The mechanism of swirl defects formation in silicon" JOURNAL OF CRYSTAL GROWTH., Bd. 59, 1982, Seiten 625-643, XP002108023 AMSTERDAM NL

## Beschreibung

Gegenstand der Erfindung ist ein Verfahren zur Herstellung eines Einkristalls aus Silicium. Die Czochralski-Methode umfaßt bekanntlich das Ziehen eines Einkristalls mit Hilfe eines Impfkristalls aus einer Schmelze, wobei die Schmelze in einem Tiegel bereitgestellt wird. Ein auf diese Weise gewonnener Einkristall (Czochralski = Cz-Einkristall) sollte möglichst wenig Kristalldefekte (as grown defects) aufweisen, weil diese bei der späteren Herstellung elektronischer Bauelemente empfindlich stören können. Dies gilt ebenso für einen Einkristall, der durch Zonenziehen (Floating Zone = FZ-Einkristall) hergestellt wird und sich unter anderem durch einen normalerweise wesentlich niedrigeren Gehalt an Sauerstoff von einem Cz-Einkristall unterscheidet.

Von Einkristallen aus Silicium ist bekannt, daß die Defektbildung unter anderem von der Ziehgeschwindigkeit und vom Temperaturgradienten an der Phasengrenze des wachsenden Einkristalls und Schmelze abhängig ist. Ist der Quotient V/G(r) beim Ziehen des Einkristalls größer als eine kritische Konstante cₖᵣᵢₜ, wobei cₖᵣᵢₜ = 1.3*10⁻³cm² min⁻¹ K⁻¹, V die Ziehgeschwindigkeit und G(r) der axiale Temperaturgradient an der Phasengrenze von Einkristall und Schmelze ist, bildet sich während des Kristallwachstums ein Überschuß an Leerstellen, die beim Abkühlen des Kristalls zu "Mikrolöchern", sogenannten voids (ca. 50 - 100 nm), aggregieren. Diese Defekte werden je nach der Präparationsmethode, mit der sie detektiert werden, als D-Defekte, Crystal Originated Particles (COP) oder Flow Pattern (FP) Defekte bezeichnet.

Je höher die Dichte dieser Defekte ist, desto schlechter ist die Durchschlagsfestigkeit der Gateoxide (gate oxide integrity = GOI) in elektronischen Bauelementen, den Endprodukten der Weiterverarbeitung der Einkristalle. Ist V/G(r) kleiner als cₖᵣᵢₜ, bildet sich ein Überschuß an Si Zwischengitteratomen, die zu sogenannten L-pits (Cz-Kristalle) bzw. A-Swirl (FZ-Kristalle) agglomerieren. Diese Si-Zwischengitteraggregationen erzeugen als Sekundärdefekte ausgedehnte Versetzungsschleifen (mehrere µm), die für die Bauelementherstellung besonders schädlich sind. Darüber hinaus vermindern die L-pits die mechanische Festigkeit des Siliciums, was sich in einer erhöhten Anfälligkeit bzgl.Vergleitungen während des Bauelementherstellprozesses bemerkbar macht. Keine der genannten Defekte werden gefunden, wenn der Quotient V/G und die Konstante cₖᵣᵢₜ beim Ziehen des Einkristalls übereinstimmen. Da der axiale Temperaturgradient G(r) mit zunehmenden radialen Abstand r vom Kristallzentrum zum Rand des Einkristalls monoton ansteigt, gibt es erhebliche ziehtechnische Schwierigkeiten, diese letztere, sehr wünschenswerte Bedingung über das gesamte Kristallvolumen einstellen. Bei Kristallen, die nahe an dieser Bedingung gezogen werden, findet man daher fast immer ein Gebiet im Zentrum des Kristalls mit Leerstellendefekten, an das sich radial-symmetrisch ein äußeres Gebiet mit L-pits (A-Swirl) anschließt. Bei Cz-Kristallen bildet sich an der ringförmigen Grenze der beiden Gebiete ein schmaler Streifen mit oxidationsinduzierten Stapelfehlern (OSF) aus. Bei FZ-Kristallen beobachtet man statt dem OSF- Ring eine ringförmige defektfreie Zone.

Um die besonders schädlichen L-pits zu vermeiden wurden bisher alle industriell verwendeten Cz-Kristalle mit einem Leerstellenüberschuß gezogen, d.h. V/G(r)>cₖᵣᵢₜ gilt über den gesamten Kristallradius, wobei versucht wurde, die Dichte der Leerstellendefekte möglichst gering zu halten. Bekannt ist, daß der Sauerstoffgehalt die Defektdichte und damit die GOI-Qualität nur wenig beeinflußt (C.Hasenack et al., Proc. 173rd Meeting Electrochem.Soc., 447 (1988)).

Gemäß Watanabe et al. kann Silicium mit kontrollierten Mengen an Sauerstoff dotiert werden (Watanabe et al., "Controlled oxygen doping in silicon", INTERNATIONAL CONFERENCE ON SOLID STATE DEVICES AND MATERIALS, Bd.22, Nr.1, 1983, Seiten 185-189).

Von FZ-Kristallen ist seit langem bekannt, daß sowohl Leerstellen- als auch Si-Zwischengitterdefekte durch eine geringe Stickstoffdotierung ( ca. 10¹⁴ atcm⁻³) simultan unterdrückt werden können. Dies führt zu einer nahezu perfekten GOI-Qualität. Dieser positive Effekt bzgl. der GOI-Qualität geht jedoch verloren, wenn zusätzlich mit Sauerstoff dotiert wird, was bei Cz-Einkristallen wegen der Benutzung eines Quarztiegels zwangsläufig der Fall ist (W.v.Ammon et al., Proc. of the Satellite Symp. to ESSDERC 93, Grenoble, The Electrochem. Soc., Vol 93-15, 36 (1993)). Bei Sauerstoff und Stickstoff dotierten FZ-Kristallen konnte zwar durch die Stickstoffdotierung noch eine Verbesserung bei den sogenannten B+ Mode Durchbrüchen im elektrischen Streßtest festgestellt werden, die jedoch ohne Bedeutung ist, da für die Bauelementhersteller nur der Prozentsatz an Kondensatoren interessant ist, der den intrinsischen Durchbruch erreicht (C+ Mode). Bei Cz-Kristallen, deren Defektdichten im Vergleich zu FZ in einer anderen Größenordnungen liegen (FZ-Kristalle sind in der Regel wegen der völlig unterschiedlichen thermischen Geschichte , der wesentlich höheren Reinheit, der schnelleren Ziehgeschwindigkeit und der völlig anderen Prozeßregelung mit Cz-Kristallen nicht vergleichbar), wurde bisher nur von Methoden der Stickstoffdotierung berichtet mit dem Ziel, die Leerstellendefektdichte zu vermindern und damit die GOI-Qualtität zu erhöhen (JP-06271399 A). Bezüglich der Defektreduzierung/GOI-Verbesserung werden jedoch keinerlei quantitativen Angaben gemacht.

Durch die Dotierung von Cz-Einkristallen mit Stickstoff beschleunigt sich die Präzipitation des Sauerstoffs im Einkristall (R.S.Hockett, Appl.Phys.Lett. 48, 1986, p.224). Während der gezogene Einkristall abkühlt beginnt der Sauerstoff bereits bei höheren Temperaturen als sonst üblich zu präzipitieren. Dies führt zu größeren Präzipitationskeimen, die ihrerseits bei einer später durchgeführten Oxidationsbehandlung einer vom Einkristall gewonnenen Halbleiterscheibe Stapelfehler auf der Oberfläche der Halbleiterscheibe erzeugen. Außerdem lösen sich die großen Präzipitate im Oberflächen nahen Bereich der Scheibe nicht ausreichend schnell während des Bauelementherstellungsprozesses auf, so daß es schwierig wird, eine defektfreie Zone (denuded zone) in der vom Bauelementhersteller spezifizierten Tiefe zu erzielen.
Es bestand daher die Aufgabe, Verfahren aufzuzeigen, wie Halbleiterscheiben aus Silicium mit möglichst geringer Defektdichte und zufriedenstellendem GOI herzustellen sind, ohne daß dabei die oben geschilderten Nachteile in Kauf genommen werden müssen. Gegenstand der Erfindung ist ein Verfahren zur Herstellung eines Einkristalls aus Silicium, der nach der Czochralski-Methode aus einem Quarztiegel gezogen und dabei mit Sauerstoff und Stickstoff dotiert wird, das dadurch gekennzeichnet ist, daß der Einkristall mit Sauerstoff einer Konzentration von 4.15*10¹⁷atcm⁻³ bis < 6.5*10¹⁷ atcm⁻³ und mit Stickstoff einer Konzentration von > 5*10¹³ atcm⁻³ während des Ziehens des Einkristalls dotiert wird.

Überraschenderweise wurde gefunden, daß beim Einstellen der genannten Ziehbedingungen die Aufgabe gelöst wird. Untersuchungen im Zusammenhang mit der Erfindung haben gezeigt, daß die Durchschlagsfestigkeit von Gateoxiden auf einer Halbleiterscheibe aus einem derartig hergestellten Cz-Einkristall deutlich ansteigt, wenn die Halbleiterscheibe Bedingungen ausgesetzt wird, die zur Herstellung elektronischer Bauelemente notwendig sind. So wurde beobachtet, daß die GOI-Ausbeute (Prozentsatz an zufrieden stellenden Testkondensatoren nach einem elektrischen Streßtest) von <25% auf über 90% nach einer Prozeßsimulation eines 4M DRAM Speichers anstieg. Der Herstellprozeß des 4M DRAM Bauelementes enthält mehrere Hochtemperaturbehandlungen (>950°C) vor der Geateoxid-Herstellung, während der die durch die erfindungsgemäßen Bedingungen offenbar verkleinerten Kristalldefekte ausheilen.

Die Verbesserung des GOI nach der Prozeßsimulation ist besonders ausgeprägt, wenn der Einkristall beim Ziehen beispielsweise mit einem ihn umgebenden wassergekühlten Wärmeschild aktiv gekühlt und so schnell wie möglich gezogen wird und je höher der Stickstoffgehalt und je niedriger der Sauerstoffgehalt ist. Bei Bauelementprozessen ohne Hochtemperaturschritte muß die Gateoxidqualität durch einen zusätzlichen Rapid Thermal Anneal Schritt mit einer Temperatur oberhalb von 1150°C weiter verbessert werden.

Weiterhin wurde gefunden, daß durch den niedrigen Sauerstoffgehalt die Stickstoff induzierte OSF-Bildung stark unterdrückt wird. So konnte der bei einem Sauerstoffgehalt von 6*10¹⁷ atcm⁻³ noch massiv ausgeprägte OSF Ring bei 5*10¹⁷ atcm⁻³ nicht mehr beobachtet werden.

Bezüglich der Sauerstoffpräzipitation wurde festgestellt, daß sich bei Sauerstoffgehalten kleiner 6.5 *10¹⁷ atcm⁻³ eine Stickstoffdotierung vorteilhaft auswirkt, da unterhalb dieser Konzentration offenbar nur noch eine Stickstoff induzierte Sauerstoffpräzipitation möglich ist. Ein radial homogen eingebauter Stickstoff führt folglich auch zu einer radial homogenen Präzipitation des Sauerstoffs, die nicht mehr von der radialen Verteilung der Leerstellen und Si-Zwischengitteratome abhängt. Vor allem aber wird durch die Stickstoff induzierte Sauerstoffpräzipitation noch eine ausreichende Getterfähigkeit des Siliciummaterials sichergestellt, die bei so niedrigen Sauerstoffgehalten sonst in Frage gestellt wäre. Dabei kann die Sauerstoffpräzipitation in einem gewissen Umfang in axialer Richtung homogenisiert werden, wenn ein in Richtung Kristallende axial fallender Sauerstoffgehalt gewählt wird, da die Stickstoffkonzentration wegen des kleinen Segregationskoeffizienten zum Kristallende hin immer ansteigt, so daß der durch den steigenden Stickstoff verstärkten Präzipitationsneigung durch die abnehmende Sauerstoffkonzentration entgegengewirkt wird. Jedoch unterhalb einer Sauerstoffkonzentration von 4,15x10¹⁷ at/cm³ konnte auch bei höheren Stickstoffkonzentrationen keine Sauerstoffpräzipitation mehr beobachtet werden. Bemerkenswerterweise wurde gefunden, daß oberhalb dieser Sauerstoffkonzentration die Getterwirkung bereits in den ersten Schritten der Bauelementanfertigung einsetzt. Dies gilt insbesondere auch für Stickstoff dotierte Epitaxie-Substrate.

Darüber hinaus konnte an Scheiben, die aus den erfindungsgemäß gezogenen Kristallen gefertigt wurden, sowohl nach einer Temperaturbehandlung von 3h 780°C, 10h 1000°C als auch nach einer 4M DRAM Prozeßsimulation eine Denuded Zone von mehr als 10 µm gemessen werden. Die Tiefe erhöht sich mit abnehmendem Sauerstoffgehalt und läßt sich somit kundenspezifisch einstellen.

Durch die erfindungsgemäßen Ziehbedingungen wird somit nicht nur eine wesentlich verbesserte GOI-Qualität im Bauelementherstellprozeß erzielt, sondern es werden auch die oben genannten Nachteile der Stickstoffdotierung vermieden. Methoden zur Steuerung des Einbaus von Sauerstoff beim Ziehen von Cz-Kristallen sind beispielsweise aus EP 0527477 B1 bekannt. Verfahren zur Dotierung von Cz-Einkristallen mit Stickstoff sind beispielsweise aus der JP-06271399 A bekannt.

Gegenstand der Erfindung ist auch ein Verfahren zur Herstellung eines Einkristalls aus einer Silicium-Schmelze, das dadurch gekennzeichnet ist, daß der Einkristall mit Stickstoff dotiert wird und der Einkristall mit einer Geschwindigkeit V gezogen wird, wobei ein axialer Temperaturgradient G(r) an der Phasengrenze von Einkristall und Schmelze eingestellt wird, bei dem der Quotient V/G(r) in radialer Richtung wenigstens teilweise kleiner als 1.3*10⁻³cm²min⁻¹ K⁻¹ ist.

Untersuchungen an Cz-Einkristallen, bei deren Herstellung der Quotient V/G(r) diesen Vorgaben genügte und die daher entweder vollständig oder teilweise Si-Zwischengitterdefekte aufweisen sollten, haben überraschenderweise ergeben, daß diese Defekte durch die Stickstoffdotierung massiv reduziert oder sogar vollständig unterdrückt werden können, obwohl der Einfluß auf die Leerstellendefektdichte vergleichsweise gering bleibt. Das heißt, im Gegensatz zu dem bekannten Wissen der simultanen Unterdrückung von Leerstellen- und Si-Zwischengitterdefekten wirkt der Stickstoff in Anwesenheit von Sauerstoff selektiv auf die Si-Zwischengitterdefekte. Die Unterdrückung von Si-Zwischengitterdefekten ist nicht nur für polierte Si-Wafer sondern auch für Epitaxie-Substrate wichtig, da Si-Zwischengitterdefekte im Gegensatz zu den Leerstellendefekten in die Epi-Schicht hineinwachsen und dort ebenfalls zu Defekten führen.

Die Stickstoffdotierung ermöglicht es nun, die Geschwindigkeit beim Ziehen des Einkristalls soweit zu senken, daß Leerstellendefekte überhaupt nicht mehr oder nur in einem inneren Bereich mit einem vergleichsweise geringen Durchmesser auftreten, ohne befürchten zu müssen, daß im äußeren Bereich der Halbleiterscheibe die schädlichen Si-Zwischengitter-Defekte entstehen. Das Verfahren erlaubt daher das Ziehen von Cz-Einkristallen und FZ-Einkristallen, die weder Leerstellen- noch Zwischengitter-Defekte enthalten. Vorzugsweise wird hierzu ein Ofenaufbau gewählt, bei dem V/G(r) nur gering mit r variiert, wobei r der radiale Abstand vom Kristallzentrum ist.

Wählt man die Ziehbedingungen so, daß V/G(r) <cₖᵣᵢₜ über den gesamtem Kristalldurchmesser gilt, so wird gleichzeitig die OSF-Bildung unterdrückt. Die Untersuchungen haben außerdem gezeigt, daß die mechanische Festigkeit der Kristalle durch die Stickstoffdotierung deutlich verbessert wird, wenn der Einkristall unter Ziehbedingungen gezogen wird , bei denen der Quotient V/G(r) < cₖᵣᵢₜ ist.

Auch bei den V/G(r)<cₖᵣᵢₜ gezogenen Kristallen ist es günstig, wenn der Sauerstoffgehalt so niedrig gewählt wird, daß nur noch eine Stickstoff induzierte Sauerstoffpräzipitation erfolgt.

## Patentansprüche

1. Verfahren zur Herstellung eines Einkristalls aus Silicium, der nach der Czochralski-Methode aus einem Quarztiegel gezogen und dabei mit Sauerstoff und Stickstoff dotiert wird, das **dadurch gekennzeichnet ist, daß** der Einkristall mit Sauerstoff einer Konzentration von 4.15*10¹⁷atcm⁻³ bis < 6.5*10¹⁷ atcm⁻³ und mit Stickstoff einer Konzentration von > 5*10¹³ atcm⁻³ während des Ziehens des Einkristalls dotiert wird.

2. Verfahren zur Herstellung eines Einkristalls aus einer Silicium-Schmelze, das **dadurch gekennzeichnet ist, daß** der Einkristall mit Stickstoff dotiert wird und der Einkristall mit einer Geschwindigkeit V gezogen wird, wobei ein axialer Temperaturgradient G(r) an der Phasengrenze von Einkristall und Schmelze eingestellt wird, bei dem der Quotient V/G(r) in radialer Richtung wenigstens teilweise kleiner als 1.3*10⁻³cm²min⁻¹K⁻¹ ist.

3. Verfahren nach Anspruch 1 oder 2, **dadurch gekennzeichnet, daß** der Einkristall beim Ziehen durch einen ihn umgebenden Wärmeschild gekühlt wird.

4. Verfahren nach einem der Ansprüche 1 bis 3, **dadurch gekennzeichnet, daß** der Einkristall mit Sauerstoff dotiert wird und die Sauerstoff-Dotierung so niedrig gewählt wird, daß eine Bildung von Sauerstoff-Präzipitaten nur aufgrund der Stickstoff-Dotierung eintritt.

5. Verfahren nach Anspruch 1 oder Anspruch 4, **dadurch gekennzeichnet, daß** die Tiefe einer Denuded Zone durch Variation der Sauerstoffkonzentration eingestellt wird.

6. Verfahren nach einem der Ansprüche 1 bis 5, **dadurch gekennzeichnet, daß** die Tiefe einer Denuded Zone durch Variation der Stickstoffkonzentration eingestellt wird.

7. Verfahren nach einem der Ansprüche 1 bis 6, **dadurch gekennzeichnet, daß** der Einkristall derart gezogen wird, daß er weder Leerstellen- noch Zwischengitterdefekte enthält.

8. Verfahren nach einem der Ansprüche 1 bis 7, **dadurch gekennzeichnet, daß** der Einkristall aktiv gekühlt wird.

9. Verfahren nach einem der Ansprüche 1 bis 8, **dadurch gekennzeichnet, daß** der Einkristall derart gezogen wird, daß die Sauerstoffkonzentration in axialer Richtung zum Kristallende hin abnimmt, während die Stickstoflkonzentration zunimmt.

10. Verfahren nach einem der Ansprüche 1 bis 9, **dadurch gekennzeichnet, daß** der Einkristall in mit Stickstoff dotierte Halbleiterscheiben geteilt wird und diese als Epi-Substrate verwendet werden.

11. Verfahren nach einem der Ansprüche 1 bis 10, **dadurch gekennzeichnet, daß** der Einkristall in mit Stickstoff dotierte Halbleiterscheiben geteilt wird und diese zusätzlich durch einen Rapid Thermal Anneal Schritt bei mindestens 1150°C getempert werden.

## Claims

1. Process for producing a silicon single crystal which is pulled from a quartz crystal using the Czochralski method while being doped with oxygen and nitrogen, which process is **characterized in that** the single crystal is doped with oxygen at a concentration of 4.15*1017 atcm-3 to < 6.5*1017 atcm-3 and with nitrogen at a concentration of > 5*1013 atcm-3 while the single crystal is being pulled.

2. Process for producing a single crystal from a silicon melt, which is **characterized in that** the single crystal is doped with nitrogen and the single crystal is pulled at a rate V, an axial temperature gradient G(r) being set up at the interphase of the single crystal and the melt, in which the ratio V/G(r) in the radial direction is at least partially less than 1.3*10-3cm2min-1 K-1.

3. Process according to Claim 1 or 2, **characterized in that** the single crystal is cooled by a heat shield surrounding it during the pulling.

4. Process according to one of Claims 1 to 3, **characterized in that** the single crystal is doped with oxygen and the oxygen doping is selected low enough for formation of oxygen precipitates to occur only because of the nitrogen doping.

5. Process according to Claim 1 or Claim 4, **characterized in that** the depth of a denuded zone is adjusted by variation of the oxygen concentration.

6. Process according to one of Claims 1 to 5, **characterized in that** the depth of a denuded zone is adjusted by variation of the nitrogen concentration.

7. Process according to one of Claims 1 to 6, **characterized in that** the single crystal is pulled in such a way that it contains neither vacancy nor interstitial defects.

8. Process according to one of Claims 1 to 7, **characterized in that** the single crystal is actively cooled.

9. Process according to one of Claims 1 to 8, **characterized in that** the single crystal is pulled in such a way that the oxygen concentration decreases in the axial direction towards the crystal end, while the nitrogen concentration increases.

10. Process according to one of Claims 1 to 9, **characterized in that** the single crystal is divided into nitrogen-doped semiconductor wafers and these are used as epi-substrates.

11. Process according to one of Claims 1 to 10, **characterized in that** the single crystal is divided into nitrogen-doped semiconductor wafers and these are additionally heat treated by a rapid thermal anneal step at at least 1150°C.

## Revendications

1. Procédé pour la préparation d'un monocristal de silicium qui est tiré à partir d'un creuset en quartz selon la méthode Czochralski et qui est dopé à cette occasion avec de l'oxygène et de l'azote, **caractérisé en ce que** le monocristal est dopé avec de l'oxygène à une concentration de 4,15*10¹⁷ atcm⁻³ à <6,5*10¹⁷ atcm⁻³ et avec de l'azote à une concentration de >5*10¹³ atcm⁻³ pendant le tirage du monocristal.

2. Procédé pour la préparation d'un monocristal à partir d'une fusion de silicium, **caractérisé en ce que** le monocristal est dopé avec de l'oxygène et que le monocristal est tiré à une vitesse V, un gradient axial de température G(r) étant ajusté à la limite de phase du monocristal et de la fusion, pour lequel la valeur du quotient V/G(r) dans la direction radiale est au moins partiellement inférieure à 1,3*10⁻³ cm² min⁻¹ K⁻¹.

3. Procédé selon la revendication 1 ou 2, **caractérisé en ce que** lors du tirage, le monocristal est refroidi par un écran thermique qui l'entoure.

4. Procédé selon l'une des revendications 1 à 3,
**caractérisé en ce que** le monocristal est dopé avec de l'oxygène et que la concentration de dopage avec l'oxygène est choisie si faible qu'une formation de précipités d'oxygène n'intervient qu'en raison du dopage avec de l'azote.

5. Procédé selon l'une des revendications 1 à 4, **caractérisé en ce que** la profondeur d'une zone dénudée est ajustée au moyen de la variation de la concentration de l'oxygène.

6. Procédé selon l'une des revendications 1 à 5, **caractérisé en ce que** la profondeur d'une zone dénudée est ajustée au moyen de la variation de la concentration de l'azote.

7. Procédé selon l'une des revendications 1 à 6, **caractérisé en ce que** le monocristal est tiré de telle sorte qu'il ne contienne ni vides, ni défauts interstitiels.

8. Procédé selon l'une des revendications 1 à 7, **caractérisé en ce que** le monocristal est refroidi de manière active.

9. Procédé selon l'une des revendications 1 à 8, **caractérisé en ce que** le monocristal est tiré de telle sorte que la concentration en oxygène diminue dans la direction axiale vers l'extrémité du cristal alors que la concentration en azote augmente.

10. Procédé selon l'une des revendications 1 à 9, **caractérisé en ce que** le monocristal est subdivisé en plaquettes de semi-conducteur dopées avec de l'azote et que celles-ci sont utilisées comme épi-substrats.

11. Procédé selon l'une des revendications 1 à 10, **caractérisé en ce que** le monocristal est subdivisé en plaquettes de semi-conducteur dopées avec de l'azote et que celles-ci sont de plus recuites par une étape rapide de recuit thermique à 1150°C au moins.
